Europäisches Patentamt

European Patent Office

Office européen des brevets

(11) Publication number: **0 229 263 B1**

## EUROPEAN PATENT SPECIFICATION

(45) Date of publication of patent specification: **25.03.92**

(51) Int. Cl.⁵: **C30B 23/02**, C30B 29/40, C30B 29/60

(21) Application number: **86116081.0**

(22) Date of filing: **20.11.86**

(54) Method of growing quaternary or pentanary compound semiconductor by MBE lattice-matched to substrate.

(30) Priority: **16.12.85 JP 282492/85**

(43) Date of publication of application:
**22.07.87 Bulletin 87/30**

(45) Publication of the grant of the patent:
**25.03.92 Bulletin 92/13**

(84) Designated Contracting States:
**DE FR GB**

(56) References cited:

**JAPANESE JOURNAL OF APPLIED PHYSICS, vol. 25, no. 3, March 1986, pages L254-L256, Tokyo, JP; T. FUJII et al.: "MBE growth of InGaAlAs lattice-matched to InP by pulsed molecular beam method"**

**APPLIED PHYSICS LETTERS, vol. 43, no. 8, October 1983, pages 762-764, American Institute of Physics, New York, US; D.F. WELCH et al.: "Optical properties of GaInAs/AlInAs single quantum wells"**

(73) Proprietor: **FUJITSU LIMITED**
**1015, Kamikodanaka Nakahara-ku**
**Kawasaki-shi Kanagawa 211(JP)**

(72) Inventor: **Fujii, Toshio**
**21-9, Morinosato 1-chome**
**Atsugi-shi Kanagawa, 243-01(JP)**

(74) Representative: **Seeger, Wolfgang, Dipl.-Phys.**
**SEEGER & SEEGER Patentanwälte & European Patent Attorneys Georg-Hager-Strasse 40**
**W-8000 München 70(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

JOURNAL OF CRYSTAL GROWTH, vol. 44, no. 1, August 1978, pages 5-13, North-Holland Publishing Co., NL; P.M. PETROFF et al.: "Crystal growth kinetics in (GaAs)n-(AlAs)m superlattices deposited by molecular beam epitaxy"

APPLIED PHYSICS LETTERS, vol. 46, no. 7, April 1985, pages 659-661, American Institute of Physics, Woodbury, New York, US; W.T. TSANG et al.: "GaSb0.5As0.5/Al0.35Ga0.65Sb0.48As0.52 superlattice lattice matched to InP prepared by molecular beam epitaxy"

## Description

## BACKGROUND OF THE INVENTION

### 1. Field of the Invention

This invention relates to a method of growing a III-V group quaternary or pentanary compound semiconductors such as InGaAlAs, InGaAlP, InGaAlAsSb, and the like by Molecular Beam Epitaxy (hereinafter abbreviated as MBE). More particularly, this invention relates to the method of growing a lattice-matched quaternary or pentanary layer on a binary substrate such as InP, GaAs, InAs, and GaSb, or on an epitaxial layer grown thereon, and thus forming single or multi-heterostructures.

### 2. Description of the Prior Art

In a heterostructure, wherein a ternary, quaternary, or pentanary compound semiconductor is grown on a binary substrate or on an epitaxial layer grown thereon having a different composition, lattice constants of both semiconductors are required to be well matched with each other to obtain high quality epitaxial layers.

As an example, in which a heterostructure of $GaAs/Al_xGa_{l-x}As$ is grown on a GaAs substrate, the epitaxial layer of $Al_xGa_{l-x}As$ is almost lattice-matched to the GaAs substrate for all x values of $0 \leq x \leq 1$. When the lattice constant of GaAs substrate is represented as $a_{ga}$ and the difference of lattice constants between GaAs and $Al_xGa_{l-x}As$ is represented as $\Delta a$, then the following condition is maintained for all x values of $0 \leq x \leq 1$,

$$\Delta a/a_{ga} \leq 0.13 \%.$$

Therefore an epitaxially growth of the $GaAs/Al_xGa_{l-x}AS$ can be obtained with very few crystal defects over a whole range of x values for $Al_xGa_{l-x}As$ semiconductors having different energy band gaps, therefore the structure is widely used in photo-diodes, lasers, high electron mobility transistors, and the like.

The above heterostructure $GaAs/Al_xGa_{l-x}AS$ is widely used as a structure for an opto-devices working on a wavelength between 0.6 and 0.9 micron meters.

As another example, the active device working on a wavelength region of 1.0 to 1.6 micron meters, a quaternary alloy semiconductor such as $In_{l-(y+z)}Ga_yAl_zAs$ (abbreviated conventionally as In-GaAlAs) is often grown on an InP substrate or on a buffer layer of a ternary compound semiconductor deposited thereon. In this case, the deviation of the lattice constant $\Delta a/a_{ip}$ has a maximum value of 3.5 % depending on values y and z composing the

quaternary, wherein $a_{ip}$ denotes a lattice constant of InP substrate and $\Delta a$ denotes a difference between the lattice constants of InP and of $In_{l-(y+z)}Ga_yAl_zAs$.

When the epitaxial layer of quaternary compound InGaAlAs is grown by MBE forming a heterostructure on a InP substrate of the prior art, a ternary semiconductor InGaAs, being lattice-matched with InP, is grown on the substrate, and then a quaternary InGaAlAs, which is also lattice-matched and has a different composition depending on a energy band gap, is grown on the ternary. Therefore a plurality of effusion cells has to be provided in MBE system, each being adjusted to generate a specified flux intensity of molecular beam to grow specified ternary and quaternary epitaxial layers. Each flux intensity is different depending on the composition of the epitaxial layer, even if the same material is utilized as one of constituents of epitaxial layers forming the heterostructure.

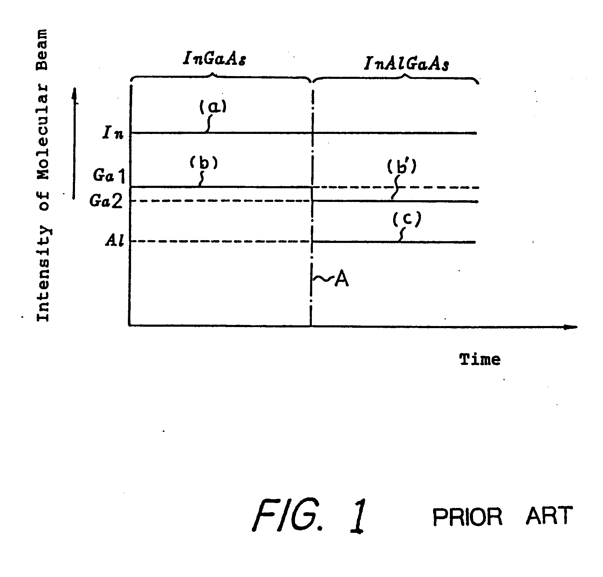

The FIG. 1 is an example of plots of each flux intensity of effusion cells versus time in growing a heterostructure InGaAs/InGaAlAs on the InP substrate. In this case, where two effusion cells $Ga_1$ and $Ga_2$ for Ga are provided besides In, Al, and As effusion cells. In the figure, a dash-dot line A shows an instant when the MBE growth is changed from ternary InGaAs to quaternary InGaAlAs. During the growth of InGaAs layer on the InP substrate, three sources are active, the first In cell having flux intensity shown by line (a), the second $Ga_1$ cell having flux intensity by line (b), and the third As cell being capable of supplying surplus molecular beam (not shown in FIG. 1).

At an instant shown by line A, the shutter of the molecular beam cell $Ga_1$ is closed, and shutters of the another (fourth) $Ga_2$ cell having flux intensity (b') and the fifth Al cell shutter having flux intensity (c) are opened, so that the quaternary InGaAlAs epilayer begins to grow. In FIG. 1, horizontal dashed line shows shutter is closed. In a case when another ternary or quaternary semiconductor having a different composition from the above is to be grown continuously in the subsequent processes forming multi-heterostructures, additional effusion cells for exclusively used for individual layers are necessary. Therefore plural cells generating molecular beams of the same material but having a different flux intensity are needed for MBE growth of a heterostructure including quaternary or pentanary epitaxial layer, because each layer has to be a different composition. Therefore, many cells should be provided inside the chamber.

If the number of effusion cells in the MBE system does not meet the above requirements and is required to be reduced to a minimum number, the epitaxial growth is once interrupted by closing all shutters immediately after the first epilayer growth, and then adjustment of each MBE cell to another flux intensity level is executed.

It is a difficult matter to accommodate a plurality of molecular beam cells of sufficient number in a limited space of MBE chamber in such a geometric arrangement that each cell faces the substrate surface and has almost equal distance from the substrate.

As for the second method of interrupting the growth for a time, and readjusting the molecular flux intensity by changing a furnace temperature of the effusion cell or the size of the shutter opening before the following growth, the processes are troublesome and a precise control is difficult, and as a result, the epitaxial layer deposited in this case tends to have crystal defects due to lattice mismatch and to have deviation in energy band gap from the expected value.

## SUMMARY OF THE INVENTION

The present invention relates to an improvement in a method of growing III-V quaternary or pentanary semiconductor layer by MBE, being well lattice-matched with a III-V substrate.

It is another object of the invention to provide a method of growing a III-V quaternary or a pentanary compound semiconductor layer by MBE, lattice-matched to the substrate, and having a specified energy band gap, minimizing the number of effusion cells used in MBE system.

It is still another object of the invention to provide a method of growing the quaternary or pentanary semiconductor layers without changing or readjusting the molecular beam intensity during whole growing processes from the first growth to the last growth forming heterostructures.

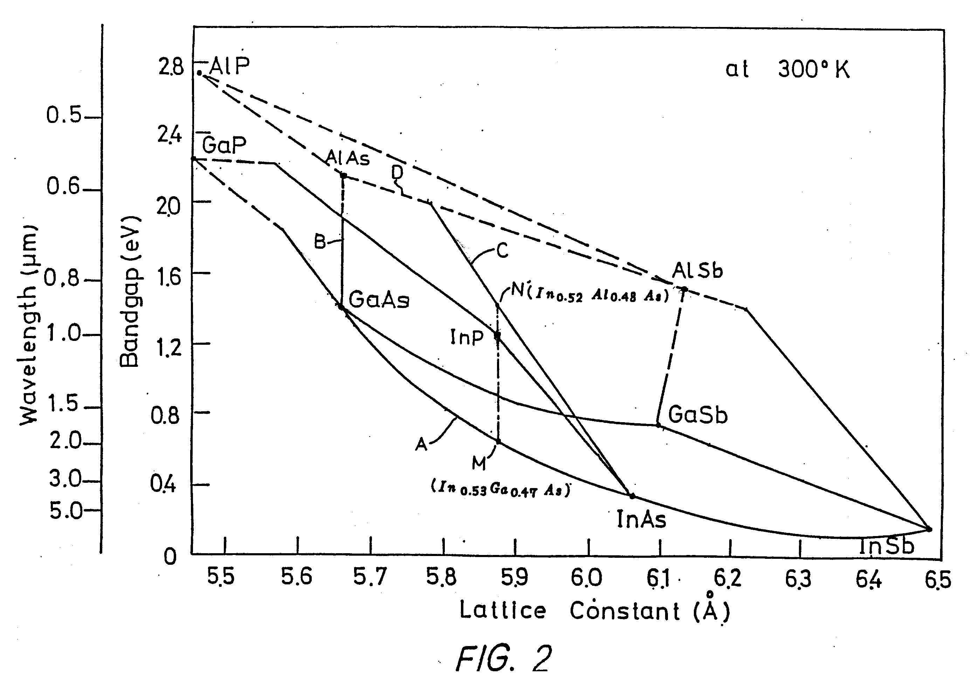

The principal concepts of the present invention are summarized using the characteristics of FIG. 2. In FIG. 2, the lattice constants and energy band gaps of binary compound semiconductors are shown by the respective specified points denoted by the names of binary semiconductors. Those for the ternary compound semiconductors are shown by curves connecting between two binary semiconductor points. In the figure, dashed lines show indirect transition regions.

When, for example, an AlGaAs layer is grown on a GaAs substrate, the connecting curve B is almost a vertical line to the abscissa, therefore lattice constants of AlGaAs are almost constant and well lattice-matched to GaAs substrate even if the composition of the ternary AlGaAs is changed. Therefore it is quite easy to form an AlGaAs layer on the GaAs substrate because it is not necessary to consider the lattice-matching but only necessary to consider the band gap.

The data for the mixed crystal (ternary compound of GaAs and InAs) $In_{l-x}Ga_xAs$ is plotted by curve A in the figure. When the x value is determined, the lattice constant and energy band gap of the ternary InGaAs are also uniquely determined by a specified point on curve A.

An compound of binary compounds AlAs and InAs also forms a ternary InAlAs compound semiconductor which is shown by two connecting lines C and D having an angle.

Point M on curve A having a composition of $In_{0.53}Ga_{0.47}As$, and point N on line C having a composition $In_{0.52}Al_{0.48}As$, have almost equal lattice constants which are also equal to that of InP substrate. Therefore these two ternary compounds are grown on InP substrate well lattice-matched as shown in FIG. 2. However, the InGaAs or InAlAs composition which can be well lattice-matched to InP substrate is indicated only by the point M or N respectively. Therefore these two layers constitute a situation different from the AlGaAs layer on GaAs substrate because each layer has only one band gap of M or N respectively.

The quaternary InGaAlAs, which is an compound of two ternary semiconductors $In_{0.53}Ga_{0.47}As$ and $In_{0.52}Al_{0.48}As$, also can have an almost equal lattice constant to InP substrate, and can have an energy band gap corresponding to a point determined by the composition ratio of above two ternaries, which is located on a line connecting two points M and N. Therefore quaternary $In_{l-(y+z)}Ga_yAl_zAs$ (in this case, $y+z = 0.47$~$0.48$) is lattice-matched with InP and has energy band gap of a value between 0.7 and 1.5 eV approximately, depending on values y and z.

In growing quaternary $In_{l-(y+z)}Ga_yAl_zAs$ continuously on a ternary epilayer by MBE of the prior art, In, Ga, and Al effusion cells, each having relative molecular beam intensity of $l-(y+z)$, y, and z respectively, and As effusion cell effusing surplus As molecules are provided. To satisfy the above condition of beam intensity, the additional effusion cell for the common elements constituting the heterostructure is separately provided in growing the quaternary layer as explained using FIG. 1.

Furthermore, in order to grow the quaternary InGaAlAs well lattice-matched to InP substrate and with a specific band gap, it is necessary to consider not only the lattice constant but also the band gap. This means there are two factors which should be considered. This shows a situation different from AlGaAs layer.

The present invention applies a new technology of growing quaternary semiconductor layer, wherein shutters of two groups of effusion cells each capable of growing the respective lattice-matched ternary semiconductors are opened and closed, the molecular beams being pulsed or changed alternatively from one set to another. In a case of InGaAlAs, two groups consist of a group of In, Ga, As cells and a group of In, Al, As cells, having In and Ga in common. According to the new technology, the band gap of the quaternary compound layer can be easily selected simply by changing the ratio of opening time of cell shutters and without considering the lattice-match. The time of each growing process is so chosen that a quaternary compound layers are formed, and not individual ternary layers. In other words, the time is specified to be less than the time for about three atomic layers growth for each process. Generally, the growth time of one monolayer or less than one monolayer for each process is more preferable.

If the thickness of each composite layer (InGaAs or InAlAs) becomes thicker than that of three atomic layers, the layer consisting of the each composite layer does not show the property of the quaternary compound layer any longer, but shows the property of superlattice structures.

In the case of growing InGaAlAs lattice-matched to InP, in first procedure, effusion cells having molecular beam flux intensities of In, Ga, and Al, being adjusted to obtain $In_{0.53}Ga_{0.47}As$ and $In_{0.52}Al_{0.48}As$ ternaries lattice-matched to InP, are provided. The adjustment can be achieved by fixing molecular beam intensities of In and As constant for both ternaries and adjusting those of Al and Ga cells against In cell respectively according to the each composition of ternaries $In_{0.53}Ga_{0.47}As$ and $In_{0.52}Al_{0.48}As$. In second procedure, the substrate is subject to the alternately pulsed molecular beams of Al and Ga, and continuous molecular beams of In and As. The compositions y and z of $In_{1-(y+z)}Ga_yAl_zAs$ is controlled by the time ratio of the pulsed molecular beam of Ga and Al. For example, if the opening time of each cells for two ternaries is less than the time during which a single atomic ternary layer can be grown and the alternate opening times are equal, InGaAlAs, lattice-matched to InP, having an energy band gap corresponding to the center value between $In_{0.53}Ga_{0.47}As$ and $In_{0.52}Al_{0.48}As$ is formed.

According to the first procedure of adjusting the Ga and Al cells against the In cell, each ternary composition of InGaAs and InAlAs of each alternate MBE processes can be lattice-matched to the InP substrate. And according to the second procedure of adjusting the time ratio of the alternate opening time of Ga and Al cell shutters, the band gap of InGaAlAs is selected without further considering the the lattice-match to the InP substrate. In the second procedure, the Ga and AL beam intensities are not changed but the time ratio of them is changed. Therefore, the growing quaternary composition is maintained to be satisfied with the lattice-matching to the InP substrate.

As III-V group semiconductors, Al, Ga, and In in the III-group elements, and P, As, and Sb in the V-group elements are well known as constituents of binary compound semiconductors such as GaAs, AlAs, InP, AlSb, GaSb, InAs, AlP, GaP, and InSb as shown in FIG. 2. These six elements also form such many kinds of compound semiconductors theoretically, as 18 ternaries, 15 quaternaries, and 6 pentanaries. However in practical applications, the ternary/quaternary heterostructures using InP, GaAs, InAs, or GaSb as a substrate are of great importance.

The present invention discloses the improved and general method of growing heterostructures consisting of III-V semiconductors well lattice-matched to the substrate and obtaining a specified energy band gap. When a change of other physical characteristic is required such as dielectric constant or the like other than above lattice-matching and energy band gap, a pentanary epilayer is effective. In this case, two groups of effusion cells capable of growing two quaternary layers are provided in MBE system, and the pentanary layer is grown by alternatively pulsed molecular beam from each group of the above effusion cells for two quaternaries.

Further objects and advantages of the present invention will be apparent from the following description, reference being had to the accompanying drawings wherein preferred embodiments of the present invention are clearly shown.

## BRIEF DESCRIPTION OF THE DRAWINGS

FIG. 1 is a plot illustrating the molecular beam intensity versus elapsed time when a ternary InGaAs semiconductor and subsequently quaternary InAlGaAs semiconductor are grown forming a heterostructure in the prior art.

FIG. 2 is a well-known plot illustrating the lattice constant and energy band gap characteristics for III-V group binary and ternary semiconductors.

FIG. 3 is a schematic, synoptic cross-sectional view of the MBE system utilized for growing a quaternary semiconductor according to the present invention.

FIG. 4 is a plot illustrating on and off state of each shutter for the four effusion cells during the growth of quaternary semiconductor according to the present invention.

FIG. 5 is a schematic cross-sectional view of a multi-heterostructures, comprising InGaAlAs quaternary, grown on InP substrate according to the present invention.

FIG. 6 is a plot showing a energy band gap of epitaxial layers shown in FIG. 5.

FIG. 7 shows a test result by PL measurement for epitaxial layers, shown in FIG. 5, being grown by a method of the present invention.

## DETAILED DESCRIPTION OF THE PREFERRED EMBODIMENTS

As a first example according to the present invention, a method of growing a quaternary InGaAlAs compound semiconductor is explained, which is lattice-matched to the InP substrate and has a specified energy band gap.

It has been explained previously using FIG. 2 that both $In_{0.53}Ga_{0.47}As$ and $In_{0.52}Al_{0.48}As$ ternaries are well lattice-matched to InP substrate. $In_{0.53}Ga_{0.47}As$ has a energy band gap of 0.75 eV and $In_{0.52}Al_{0.48}As$, 1.47 eV. A quaternary semiconductor InGaAlAs, lattice-matched to InP and having a energy band gap between those of $In_{0.53}Ga_{0.47}As$ and $In_{0.52}Al_{0.48}As$ ternaries, can be obtained, when the composition of the quaternary is given by a form of $m(In_{0.53}Ga_{0.47}As) + n(In_{0.52}Al_{0.48}As)$, where m and n are arbitrary numbers and determine the energy band gap. In another expression using a form of $In_{I-(y+z)}Ga_yAl_zAs$, when the condition of $y + z = 0.47\sim0.48$ is satisfied, the quaternary InGaAlAs is lattice-matched to InP and has the energy band gap between 0.75 and 1.47 eV.

Therefore, in the present invention, since each Ga and Al beam intensity is adjusted against that of In in the first procedure, i.e. x of $In_{I-x}Ga_xAs$ and $In_{I-x}Al_xAs$ is adjusted to $0.47\sim0.48$ respectively, the above condition of $y + z = 0.47\sim 0.48$ is always satisfied even by alternately switching the Ga and Al cell shutters in the second procedure.

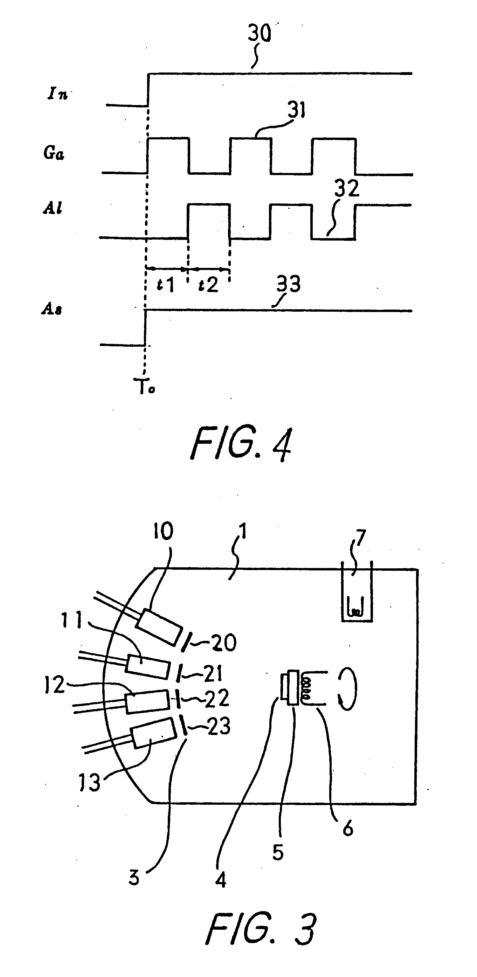

FIG. 3 is a schematic, synoptic cross sectional view of the MBE system utilized for the growth of the above InGaAlAs. Four effusion cells 10, 11, 12, and 13 are provided in high vacuum chamber 1, each being used as a source of molecular beam of In, Ga, Al, and As respectively. Each cell is loaded in a furnace (integrated with the cell and not shown in the figure) and the molecular beam intensity from the cell can be controlled by varying a temperature of the furnace. Each effusion cell also provides a shutter shown as 20 to 23. The shutter can be closed or opened, and thus each molecular beam can be controlled on and off.

InP substrate 4 is fixed to a substrate holder 5, and the temperature of the substrate can be raised to a specified temperature by a heater 6. Quadrupole mass spectrometer 7 is provided for monitoring the growth.

Before the growing process, the molecular beam intensities of In and Ga are so adjusted that a ternary semiconductor having a composition of $In_{0.53}Ga_{0.47}As$ can be growable with a growth rate of 0.264 micron meters per hour on the conditions of $2\times10^{-5}$ Torr As pressure and 500°C substrate temperature. This growth rate is equivalent to a growth of one atomic layer per four seconds.

Then the molecular beam intensity of Al is so adjusted as to grow $In_{0.52}Al_{0.48}As$ ternary using the same molecular beam intensity of In previously adjusted for $In_{0.53}Ga_{0.47}As$. The molecular beam intensity of As is surplus.

The shutter operations are schematically shown in FIG. 4, where the abscissa shows the elapsed time of growth. Four lines having steps illustrate opened or closed conditions of each shutter, wherein upper line shows the shutter is opened and lower line, closed. The plots 30 through 33 show the operation for In, Ga, Al, and As respectively. Shutters of In and As effusion cells 10 and 13 are always open during the growth. When the growth of quaternary InGaAlAs begins at a moment $T_0$ in FIG. 4, three effusion cells of In, Ga, and As are depositing molecules on the substrate 4 during a period $t_1$, thereafter the shutter 21 for Ga is closed and the shutter 22 for Al is opened for a period of $t_2$. These processes are repeated plural times until the necessary thickness of quaternary is obtained.

When the periods $t_1$ and $t_2$ are chosen as two seconds each, then each period corresponds to one half atomic layer, because beam intensities are so adjusted as one monolayer per four seconds as described before. This results in a continuous compound growth of quaternary InGaAlAs lattice-matched to InP.

If the thickness of each composite layer (InGaAs or InAlAs) becomes thicker than that of three atomic layers, the layer consisting of the each composite layer does not show the property of the quaternary compound layer any longer, but shows the property of superlattice structures.

Even though the periods of $t_1$ and $t_2$ are not so critical, the growth time of less than three atomic layers is practical (one atomic layer or less than that is preferable).

When the period of growing $In_{0.53}Ga_{0.47}As$ is almost equal to that of $In_{0.52}Al_{0.48}As$, grown quaternary InGaAlAs has a energy band gap of almost center value between two ternaries of $In_{0.53}Ga_{0.47}As$ and $In_{0.52}Al_{0.48}As$. The grown quaternary InGaAlAs is more plainly expressed as $(In_{0.53}Ga_{0.47}As)_{\frac{1}{2}}$-$(In_{0.52}Al_{0.48}As)_{\frac{1}{2}}$ than a form of $In_{0.525}Ga_{0.235}Al_{0.24}As$.

When the periods of $t_1$ and $t_2$ are changed such that $t_1$ equals to one second and $t_2$ three seconds, then the following quaternary can be obtained,

$$(In_{0.53}Ga_{0.47}As)_{\frac{1}{4}}(In_{0.52}Al_{0.48}As)_{\frac{3}{4}}.$$

In a similar way when $t_1$ and $t_2$ are selected as three seconds and one second respectively, the following quaternary is formed,

$(In_{0.53}Ga_{0.47}As)_{3/4}(In_{0.52}Al_{0.48}As)_{1/4}$.

It is easily understood that when a ratio $t_1/t_2$ increases, the energy band gap of grown quaternary approaches that of $In_{0.53}Ga_{0.47}As$. Therefore by controlling periods of $t_1$ and $t_2$ quaternary InGaAlAs, having the specified value of energy band gap between 0.75 and 1.47 eV can be obtained.

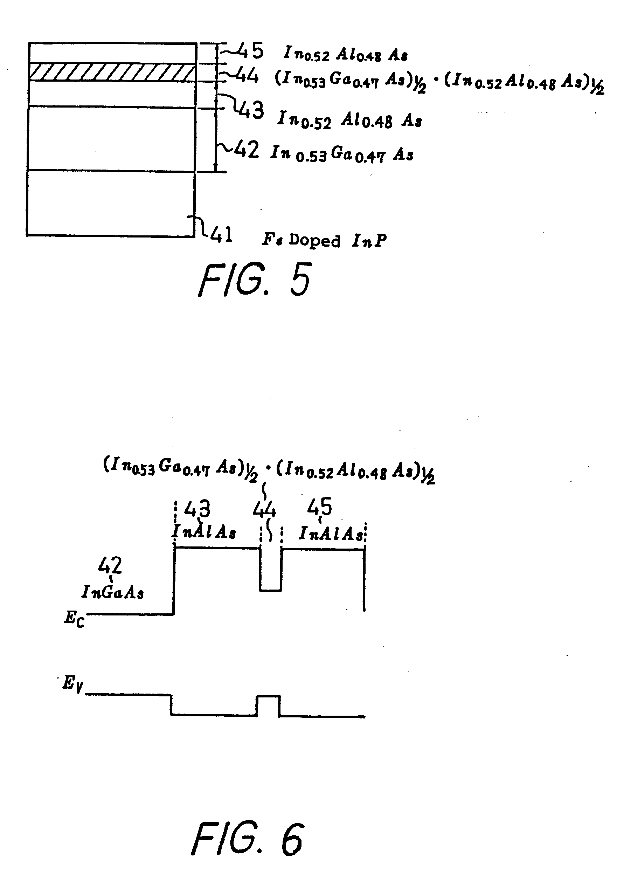

The above method is applied easily to form a ternary/quaternary or quaternary/ternary heterostructure. When the period of $t_1$ or $t_2$ in FIG. 4 is long enough, the ternary $In_{0.53}Ga_{0.47}As$ or $In_{0.52}Al_{0.48}As$ can be grown. FIG. 5 shows an example of forming a multi-heterostructures, wherein on a Fe doped InP substrate 41, $In_{0.53}Ga_{0.47}As$ layer 42 (0.6 micron meters), $In_{0.52}Al_{0.48}As$ layer 43 (0.2 micron meters), quaternary $(In_{0.53}Ga_{0.47}As)_{1/2}$-$(In_{0.52}Al_{0.48}As)_{1/2}$ layer 44 (200 Angstroms), and $In_{0.52}Al_{0.48}As$ layer 45 (0.2 micron meters) are grown in order, forming a quantum-well.

In growing the above structure, MBE system of FIG. 3 can be used untouched. $In_{0.53}Ga_{0.47}As$ layer 42 is first formed using effusion cells 10, 11, and 13 for In, Ga, and As respectively, and next the shutter of Ga effusion cell 11 is closed and the shutter of Al effusion cell 12 is opened, then $In_{0.52}Al_{0.48}As$ layer 43 begins to grow. After the growth of layer 43, the method of growing quaternary InGaAlAs 44 in accordance to the present invention is applied by opening and closing the shutters 21 and 22 alternatively as explained previously by FIG. 4. After the growth of quaternary layer 44, the ternary $In_{0.52}Al_{0.48}As$ layer 45 is again grown.

FIG. 6 shows a diagram of energy band gap of the structure of FIG. 5.

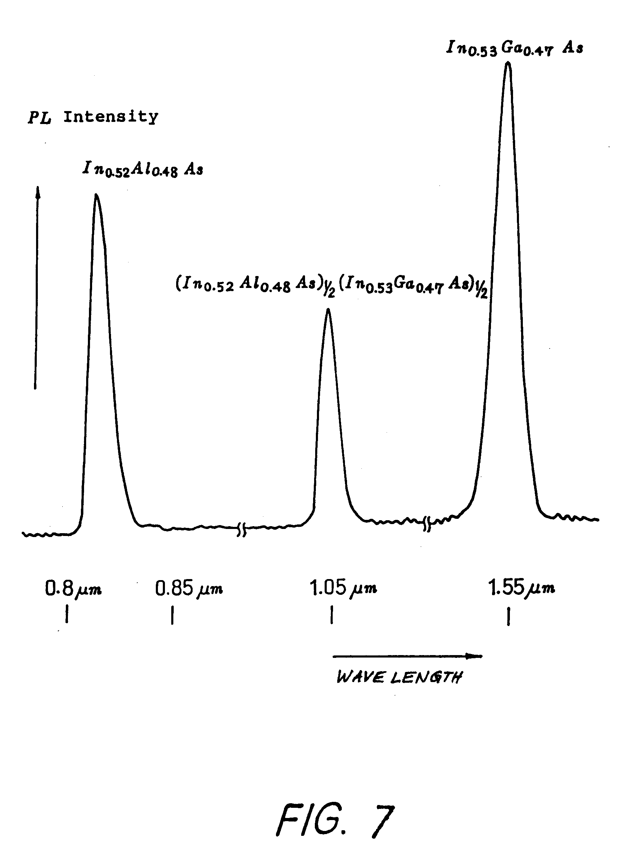

The $(In_{0.53}Ga_{0.47}As)_{1/2}(In_{0.52}Al_{0.48}As)_{1/2}$ quaternary layer 44 sandwiched by two ternary $In_{0.52}Al_{0.48}As$ layers 43 and 45 is forming a quantum-well. FIG. 7 shows a test result of the above quantum-well by the PL (photoluminescence) measurement at 4.2 K. At the middle portion along the abscissa between two peaks indicating $In_{0.52}Al_{0.48}As$ and $In_{0.53}Ga_{0.47}As$ PL intensities, the peak for $(In_{0.53}Ga_{0.47}As)_{1/2}(In_{0.52}Al_{0.48}As)_{1/2}$ layer can be observed, this shows the fact that quaternary is grown by the present invention.

When the growing processes of layers 44 and 45 are repeated plural times and the thickness of both layers are chosen such as 30 to 50 Angstroms, a multi-quantum-well is formed.

The first example disclosed above comprises III-group elements Al, Ga, and In, and V-group element As. In growing III-V quaternary semiconductor, many combinations of III-V elements can be expected. V-group elements P and Sb are available instead of As.

Among III-group elements, Al and Ga elements have a close relationship in that these two elements have resemblance in an atomic radius. It is also understood by FIG. 2 that each of three groups of binary compound semiconductors AlP and GaP, AlAs and GaAs, and AlSb and GaSb has almost the same lattice constant but has a different energy band gap. Therefore use of two ternaries, one comprising Al element and the other Ga element, and both comprising same elements except these Al and Ga are very convenient for growing quaternary semiconductor lattice-matched.

Aside from the growth of quaternary InGaAlAs already explained, three kinds of quaternary semiconductor can be grown by modifying the method applied in InGaAlAs growth.

(a) InGaAlP can be grown using two ternaries of InGaP and InAlP lattice-matched to GaAs substrate. This means four cells of In, P, Ga, and Al are used, each beam intensity of Ga and Al is adjusted against to the same intensity of In, and InGaAlP is grown by alternately switching the cell shutters of Ga and Al and by continuously radiating the In and P molecular beams.

(b) AlGaAsSb can be grown using two ternaries of AlAsSb and GaAsSb lattice-matched to InP substrate. In this example, firstly the As and Sb beam intensities are adjusted so that two ternaries being lattice-matched to InP substrate. Then, secondly, the Ga and Al beams are alternately switched by keeping the As and Sb beam intensities constant.

(c) AlGaPSb can be grown using two ternaries of AlPSb and GaPSb lattice-matched to InP or GaAs substrate. In this example, firstly, the P and Sb beam intensities are adjusted so as two ternaries being lattice-matched to InP substrate. Then, secondly, the Ga and Al beams are alternately switched by keeping the P and Sb beam intensities constant.

(d) InGaAlSb can be grown using two ternaries of InGaSb and InAlSb lattice-matched to a possible ternary substrate in the same way as the above.

(e) AlGaPAs can be grown using two ternaries of GaPAs and AlPAs lattice-matched to a possible ternary substrate in the same way as the above.

The embodiments so far disclosed are related to the method of growing quaternary semiconductor lattice-matched to the substrate and having a specified energy band gap. The present invention can be extended to a method of growing a pentanary semiconductor lattice-matched to a binary substrate and having a specified energy band gap.

Pentanary semiconductors have advantages of permitting independent variation of a physical characteristic such as dielectric constant, index of refraction or the like.

In growing a pentanary semiconductor, five effusion cells are provided in MBE system. As an example of growing a pentanary InGaAlAsSb, five effusion cells of In, Ga, Al, As, and Sb are provided. Two groups of four effusion cells (i.e. a group of In, Ga, As, Sb cells and a group of In, Al, As Sb cells, here In, As, Sb are common) are used to generate pulsed molecular beams, each group being capable of growing a quaternary lattice-matched to the substrate. One set includes Al cell and the other Ga cell, just same as in the case of growing quaternary.

More preferably, all effusion cells except for Al and Ga are commonly provided and only Al and Ga cell shutters are alternately opened and closed. As the first procedure, the Ga and Al beam intensities are adjusted against that of In, and As beam intensity is adjusted against Sb beam so as to make InGaAsSb and InAlAsSb lattice-matched to the InP substrate respectively. In the second procedure, Al and Ga cells are alternately opened and closed by keeping the other beam intensities constant. During the growth of pentanary, shutters for three effusion cells of In, As, and Sb are always opened and the shutters of Ga and Al are opened and closed alternatively, which is a similar way explained in growing quaternary (the period of each pulse is also less than the growth time for three atomic layers). Then molecular beams capable of forming two quaternaries InGaAsSb and InAlAsSb are pulsed alternatively, and then pentanary InGaAlAsSb is grown on the substrate. Binary semiconductor such as InP, or InAs, or GaSb can be used as the substrate for the growth.

In the similar way, the method of growing other three pentanaries are disclosed as follows.

(a) InGaAlAsP can be grown using two quaternaries InGaAsP and InAlPAs lattice-matched to GaAs or InP substrate.

(b) InGaAlPSb can be grown using two quaternaries InGaPSb and InAlPSb lattice-matched to GaAs, InP InAs, or GaSb substrate.

(c) GaAlPAsSb can be grown using two quaternaries GaPAsSb and AlPAsSb lattice-matched to GaAs, InP, or InAs substrate.

Although only several embodiments of the invention have been disclosed and described, it is apparent that other embodiments and modification of the invention are possible.

## Claims

1. A method of growing a III-V group quaternary compound semiconductor lattice-matched to a substrate of III-V group binary compound semiconductor by MBE, said method comprising the steps of:

(a) providing four effusion cells including an Al cell and a Ga cell and two selected cells from In, P, As and Sb cells,

(b) heating the substrate to a predetermined temperature by a heating means,

(c) adjusting each molecular beam intensity of said two selected effusion cells and one of the Al and Ga effusion cells of a first group by changing the temperature of each effusion cell such that an operation of the first group of said two selected effusion cells and one of the Al and Ga effusion cells grows a first ternary semiconductor of three elements comprised in each cell of said first group which satisfies a condition of having substantially the same lattice constant as that of the III-V binary compound semiconductor substrate, and adjusting a remaining molecular beam intensity of the other one of the Al and Ga effusion cells by changing the temperature of the effusion cell, while maintaining the molecular beam intensity of the first group of effusion cells, such that an operation of a second group of said two selected effusion cells and the other one of the Al and Ga effusion cells grows a second ternary semiconductor of three elements comprised in each cell of said second group which satisfies a condition of having substantially the same lattice constant as that of the III-V binary compound semiconductor substrate,

(d) operating only said first group of effusion cells by opening one of the Al and Ga effusion cells and closing the other one of the effusion cells while opening said two selected effusion cells for a first growth period which is less than or equal to the time required to grow three atomic layers,

(e) operating only said second group of effusion cells by opening the other one of the Al and Ga effusion cells and closing the one of the effusion cells while opening said two selected effusion cells for a second growth period which is less than or equal to the time required to grow three atomic layers, and

(f) repeating steps (d) and (e) alternately without interruption resulting in growing the quaternary semiconductor having substantially the same lattice constant as that of the III-V compound semiconductor substrate until a necessary thickness of said quaternary semiconductor is obtained.

2. A method of growing a III-V group quaternary semiconductor according to claim 1, wherein said first and second growth periods in said steps (d) and (e) have a ratio determined by an energy band gap of said growing quaternary semiconductor, the energy band gap having a specified value between those of the first and second ternary semiconductors.

3. A method of growing a III-V group quaternary semiconductor according to claim 1 or 2, wherein an InGaAlAs quaternary semiconductor is grown lattice-matched on an InP binary compound semiconductor substrate, and said two selected effusion cells are the In and As cells, and said first and second ternary semiconductors are InGaAs and InAlAs lattice-matched to said InP substrate.

4. A method of growing a III-V group quaternary semiconductor according to claim 1 or 2, wherein an InGaAlP quaternary semiconductor is grown lattice-matched on a GaAs binary compound semiconductor substrate, and said two selected effusion cells are the In and P cells, and said first and second ternary semiconductors are InGaP and InAlP lattice-matched to said GaAs substrate.

5. A method of growing a III-V group quaternary semiconductor according to claim 1 or 2, wherein an AlGaAsSb quaternary semiconductor is grown lattice-matched on an InP binary compound semiconductor substrate, and said two selected effusion cells are the As and Sb cells, and said first and second ternary semiconductors are AlAsSb and GaAsSb lattice-matched to said InP substrate.

6. A method of growing a III-V group quaternary semiconductor according to claim 1 or 2, wherein an AlGaPSb quaternary semiconductor is grown lattice-matched on an InP or GaAs binary compound semiconductor substrate, and said two selected effusion cells are the P and Sb cells, and said first and second ternary semiconductors are AlPSb and GaPSb lattice-matched to said InP or GaAs substrate respectively.

7. A method of growing a III-V group quaternary semiconductor according to any of claims 1 to 6, wherein said method further comprises an additional step (f') either before or after said step (f), said additional step (f') including the step of growing one of said first and second ternary semiconductors under the same conditions as set up in said step (c) until a necessary thickness of said one of the first and second ternary semiconductors is obtained, whereby a heterostructure of ternary/quaternary is obtained.

8. A method of growing a III-V group quaternary semiconductor according to any of claims 1 to 6, wherein said method further comprises additional steps (f') and (f'') before and after said step (f) respectively, each of said steps (f') and (f'') including a step of growing one of said first and second ternary semiconductors under the same conditions as set up in said step (c) until a necessary thickness of said one of the first and second ternary semiconductors is obtained, whereby a quaternary layer sandwiched by two ternary semiconductor layers or a quantum well is formed.

9. A method of forming said quantum well according to claim 7, wherein said method further comprises a step of repeating said steps (f) and (f') alternately plural times, whereby a multi quantum well is formed.

10. A method of growing a III-V group pentanary compound semiconductor lattice-matched to a substrate of III-V binary compound semiconductor by MBE, said method comprising the steps of:
   (a) providing five effusion cells including an Al cell and a Ga cell and three selected cells from In, P, As and Sb cells,
   (b) heating the substrate to a predetermined temperature by a heating means,
   (c) adjusting each molecular beam intensity of said three selected effusion cells and one of the Al and Ga effusion cells of a first group by changing the temperature of each effusion cell such that an operation of the first group of said three selected effusion cells and one of the Al and Ga effusion cells grows a first quaternary semiconductor of four elements comprised in each cell of said first group which satisfies a condition of having substantially the same lattice constant as that of the III-V binary compound semiconductor substrate, and adjusting a remaining molecular beam intensity of the other one of the Al and Ga effusion cells by changing the temperature of the effusion cell, while maintaining the molecular beam intensity of the first group of effusion cells, such that an operation of said second group of said three selected effusion cells and the other one of the Al and Ga effusion cells grows a second quaternary semiconductor of four elements comprised in each cell of said second group which satisfies a condition of having substantially the same lattice constant as that of the III-V binary compound semiconductor substrate,
   (d) operating only said first group of effusion cells by opening one of the Al and Ga effusion cells and closing the other one of the effusion cells while opening said three selected effusion cells for a first growth period which is less than or equal to the time required to grow three atomic layers,

(e) operating only said second group of effusion cells by opening the other one of the Al and Ga effusion cells and closing the one of the effusion cells while opening said three selected effusion cells for a second growth period which is less than or equal to the time required to grow three atomic layers, and

(f) repeating steps (d) and (e) alternately without interruption resulting in growing the pentanary semiconductor having substantially the same lattice constant as that of the III-V compound semiconductor substrate until a necessary thickness of said quaternary semiconductor is obtained.

11. A method of growing a III-V group pentanary semiconductor according to claim 10, wherein said first and second growth periods in said steps (d) and (e) have a ratio determined by an energy band gap of said growing pentanary semiconductor, the energy band gap having a specified value between those of the first and second quaternary semiconductors.

12. A method of growing a III-V group pentanary semiconductor according to claim 10 or 11, wherein an InGaAlAsSb pentanary semiconductor is grown lattice-matched on a binary compound semiconductor substrate of anyone selected from a group of InP, InAs, and GaSb, and said three selected effusion cells are the In, As and Sb cells, and said first and second quaternary semiconductors are InGaAsSb and InAlAsSb lattice-matched to said binary compound semiconductor substrate.

13. A method of growing a III-V group pentanary semiconductor according to claim 10 or 11, wherein an InGaAlPAs pentanary semiconductor is grown lattice-matched on a binary compound semiconductor substrate of one selected from a group of GaAS and InP, and said three selected effusion cells are the In, P and As cells, and said first and second quaternary semiconductors are InGaPAs and InAlPAs lattice-matched to said binary compound semiconductor substrate.

14. A method of growing a III-V group pentanary semiconductor according to claim 10 or 11, wherein an InGaAlPSb pentanary semiconductor is grown lattice-matched on a binary compound semiconductor substrate selected from a group of GaAs, InP, InAs and GaSb, and said three selected effusion cells are the In, P and Sb cells, and said first and second quaternary semiconductors are InGaPSb and InAlPSb lattice-matched to said binary compound semiconductor substrate.

15. A method of growing a III-V group pentanary semiconductor according to claim 10 or 11, wherein a GaAlPAsSb pentanary semiconductor is grown lattice-matched on a binary compound semiconductor substrate selected from a group of GaAs, InP and InAs, and said three selected effusion cells are the P, As and Sb cells, and said first and second quaternary semiconductors are GaPAsSb and AlPAsSb lattice-matched to said binary compound semiconductor substrate.

**Revendications**

1. Procédé de croissance d'un composé semiconducteur quaternaire du groupe III-V à réseau cristallin adapté à un substrat d'un composé semiconducteur binaire du groupe III-V au moyen d'un procédé d'épitaxie par jet moléculaire (MBE), ledit procédé comprenant les étapes de :

(a) fournitures de quatre cellules d'effusion incluant une cellule d'Al et une cellule de Ga et deux cellules sélectionnées parmi des cellules d'In, de P, d'As et de Sb ;

(b) chauffage du substrat jusqu'à une température prédéterminée à l'aide d'un moyen de chauffage ;

(c) ajustement de chaque intensité de jet moléculaire desdites deux cellules d'effusion sélectionnées et d'une des cellules d'effusion d'Al et de Ga d'un premier groupe en modifiant la température de chaque cellule d'effusion de telle sorte qu'un fonctionnement du premier groupe desdites deux cellules d'effusion sélectionnées et d'une des cellules d'effusion d'Al et de Ga fasse croître un premier semiconducteur ternaire de trois éléments compris dans chaque cellule dudit premier groupe qui satisfasse une condition qui consiste à avoir sensiblement la même constante de réseau que celle du substrat de composé semiconducteur binaire du groupe III-V, et l'ajustement d'une intensité de jet moléculaire restant de l'autre des cellules d'effusion d'Al et de Ga en modifiant la température de la cellule d'effusion tout en maintenant l'intensité du jet moléculaire du premier groupe de cellules d'effusion de telle sorte qu'un fonctionnement d'un second groupe desdites deux cellules d'effusion sélectionnées et de l'autre des cellules d'effusion d'Al et de Ga fasse croître un second semiconducteur ternaire de trois éléments compris dans chaque cellule dudit second groupe qui satisfasse une condition qui consiste à avoir sensiblement la même constante de réseau que celle du substrat de composé semiconducteur binaire du groupe III-V ;

(d) le fonctionnement de seulement ledit premier groupe de cellules d'effusion en ouvrant l'une des cellules d'effusion d'Al et de Ga et en fermant l'autre des cellules d'effusion tout en ouvrant lesdites deux cellules d'effusion sélectionnées pour une première période de croissance qui est inférieure ou égale à la durée nécessaire pour faire croître trois couches atomiques ;

(e) le fonctionnement seulement dudit second groupe de cellules d'effusion en ouvrant l'autre des cellules d'effusion d'Al et de Ga et en fermant l'une des cellules d'effusion tout en ouvrant lesdites deux cellules d'effusion sélectionnées pour une seconde période de croissance qui est inférieure ou égale à la durée nécessaire pour faire croître trois couches atomiques ;

(f) la répétition des étapes (d) et (e) alternativement sans interruption, ce qui conduit à la croissance du semiconducteur quaternaire qui a sensiblement la même constante de réseau que celle du substrat de composé semiconducteur du groupe III-V jusqu'à ce qu'une épaisseur nécessaire dudit semiconducteur quaternaire soit obtenue.

2. Procédé de croissance d'un semiconducteur quaternaire du groupe III-V selon la revendication 1, dans lequel lesdites première et seconde périodes de croissance desdites étapes (d) et (e) ont un rapport déterminé par une largeur de bande interdite d'énergie dudit semiconducteur quaternaire obtenu par croissance, la largeur de bande interdite d'énergie ayant une valeur spécifiée entre celles des premier et second semiconducteur ternaires.

3. Procédé de croissance d'un semiconducteur quaternaire du groupe III-V selon la revendication 1 ou 2, dans lequel un semiconducteur quaternaire en InGaAlAs est obtenu par croissance de manière à être à réseau cristallin adapté sur un substrat de composé semiconducteur binaire en InP et lesdites deux cellules d'effusion sélectionnées sont les cellules d'In et d'As et lesdits premier et second semiconducteurs ternaires sont en InGaAs et en InAlAs qui sont à réseau cristallin adapté audit substrat en InP.

4. Procédé de croissance d'un semiconducteur quaternaire du groupe III-V selon la revendication 1 ou 2, dans lequel un semiconducteur quaternaire en InGaAlP est obtenu par croissance de manière à être à réseau cristallin adapté sur un substrat de composé semiconducteur binaire en GaAs et lesdites deux cellules d'effusion sélectionnées sont les cellules d'In et de P et lesdits premier et second semiconducteurs ternaires sont en InGaP et en InAlP qui sont à réseau cristallin adapté audit substrat en GaAs.

5. Procédé de croissance d'un semiconducteur quaternaire du groupe III-V selon la revendication 1 ou 2, dans lequel un semiconducteur quaternaire en AlGaAsSb est obtenu par croissance de manière à être à réseau cristallin adapté sur un substrat de composé semiconducteur binaire en InP et lesdites deux cellules d'effusion sélectionnées sont les cellules d'As et de Sb et lesdits premier et second semiconducteurs ternaires sont en AlAsSb et en GaAsSb qui sont à réseau cristallin adapté audit substrat en InP.

6. Procédé de croissance d'un semiconducteur quaternaire du groupe III-V selon la revendication 1 ou 2, dans lequel un semiconducteur quaternaire en AlGaPSb est obtenu par croissance de manière à être à réseau cristallin adapté sur un substrat de composé semiconducteur binaire en InP ou en GaAs et lesdites deux cellules d'effusion sélectionnées sont les cellules de P et de Sb et lesdits premier et second semiconducteurs ternaires sont en AlPSb et en GaPSb qui sont à réseau cristallin adapté respectivement auxdits substrats en InP ou en GaAs.

7. Procédé de croissance d'un semiconducteur quaternaire du groupe III-V selon l'une des revendications 1 à 6, dans lequel ledit procédé comprend en outre une étape supplémentaire (f') qui se situe soit avant, soit après ladite étape (f), ladite étape étape supplémentaire (f') incluant l'étape de croissance d'un desdits premier et second semiconducteurs ternaires dans les mêmes conditions qu'établies au niveau de ladite étape (c) jusqu'à ce qu'une épaisseur nécessaire dudit un des premier et second semiconducteur ternaires soit obtenue et ainsi, une hétérostructure ternaire/quaternaire est obtenue.

8. Procédé de croissance d'un semiconducteur quaternaire du groupe III-V selon l'une des revendications 1 à 6, dans lequel ledit procédé comprend en outre les étapes supplémentaires (f') et (f'') respectivement avant et après ladite étape (f), chacune desdites étapes (f') et (f'') incluant une étape de croissance d'un desdits premier et second semiconducteurs ternaires danse les mêmes conditions qu'établies au niveau de ladite étape (c) jusqu'à ce qu'une épaisseur nécessaire dudit un desdits premier et second semiconducteurs ternaires soit obtenue et ainsi, une couche quaternaire prise en sandwich par deux couches semiconductrices ternaires ou un puits quantique est formé.

9. Procédé de formation dudit puits quantique selon la revendication 7, dans lequel ledit procédé comprend en outre une étape de répétition desdites étapes (f) et (f') alternativement plusieurs fois et ainsi, un puits multi-quantique est formé.

10. Procédé de croissance d'un composé semiconducteur pentanaire du groupe III-V à réseau cristallin adapté à un substrat d'un composé semiconducteur binaire du groupe III-V au moyen d'un procédé d'épitaxie par jet moléculaire (MBE), ledit procédé comprenant les étapes de :

(a) fournitures de cinq cellules d'effusion incluant une cellule d'Al, une cellule de Ga et trois cellules sélectionnées parmi des cellules d'In, de P, d'As et de Sb ;

(b) chauffage du substrat jusqu'à une température prédéterminée à l'aide d'un moyen de chauffage ;

(c) ajustement de chaque intensité de jet moléculaire desdites trois cellules d'effusion sélectionnées et d'une dès cellules d'effusion d'Al et de Ga d'un premier groupe en modifiant la température de chaque cellule d'effusion de telle sorte qu'un fonctionnement du premier groupe desdites trois cellules d'effusion sélectionnées et d'une des cellules d'effusion d'Al et de Ga fasse croître un premier semiconducteur quaternaire de quatre éléments compris dans chaque cellule dudit premier groupe qui satisfasse une condition qui consiste à avoir sensiblement la même constante de réseau que celle du substrat de composé semiconducteur binaire du groupe III-V, et l'ajustement d'une intensité de jet moléculaire restant de l'autre des cellules d'effusion d'Al et de Ga en modifiant la température de la cellule d'effusion tout en maintenant l'intensité de jet moléculaire du premier groupe de cellules d'effusion de telle sorte qu'un fonctionnement d'un second groupe desdites trois cellules d'effusion sélectionnées et de l'autre des cellules d'effusion d'Al et de Ga fasse croître un second semiconducteur quaternaire de quatre éléments compris dans chaque cellule dudit second groupe qui satisfasse une condition qui consiste à avoir sensiblement la même constante de réseau que celle du substrat de composé semiconducteur binaire du groupe III-V ;

(d) le fonctionnement de seulement ledit premier groupe de cellules d'effusion en ouvrant l'une des cellules d'effusion d'Al et de Ga et en fermant l'autre des cellules d'effusion tout en ouvrant lesdites trois cellules d'effusion sélectionnées pour une première période de croissance qui est inférieure ou égale à la durée nécessaire pour faire croître trois couches atomiques ;

(e) le fonctionnement seulement dudit second groupe de cellules d'effusion en ouvrant l'autre des cellules d'effusion d'Al et de Ga et en fermant l'une des cellules d'effusion tout en ouvrant lesdites trois cellules d'effusion sélectionnées pour une seconde période de croissance qui est inférieure ou égale à la durée nécessaire pour faire croître trois couches atomiques ;

(f) la répétition des étapes (d) et (e) alternativement sans interruption, ce qui conduit à la croissance du semiconducteur pentanaire qui a sensiblement la même constante de réseau que celle du substrat de composé semiconducteur du groupe III-V jusqu'à ce qu'une épaisseur nécessaire dudit semiconducteur quaternaire soit obtenue.

11. Procédé de croissance d'un semiconducteur pentanaire du groupe III-V selon la revendication 10, dans lequel lesdites première et seconde périodes de croissance desdites étapes (d) et (e) ont un rapport déterminé par une largeur de bande interdite d'énergie dudit semiconducteur pentanaire obtenu par croissance, la largeur de bande interdite d'énergie ayant une valeur spécifiée entre celles des premier et second semiconducteur quaternaires.

12. Procédé de croissance d'un semiconducteur pentanaire du groupe III-V selon la revendication 10 ou 11, dans lequel un semiconducteur pentanaire en InGaAlAsSb est obtenu par croissance de manière à être à réseau cristallin adapté sur un substrat de composé semiconducteur binaire sélectionné parmi un groupe composé par l'InP, l'InAs et le GaSb et lesdites trois cellules d'effusion sélectionnées sont les cellules d'In, d'As et de Sb et lesdits premier et second semiconducteurs quaternaires sont en InGaAsSb et en InAlAsSb qui sont à réseau cristallin adapté audit substrat de composé semiconducteur binaire.

13. Procédé de croissance d'un semiconducteur pentanaire du groupe III-V selon la revendication 10 ou 11, dans lequel un semiconducteur pentanaire en InGaAlPAs est obtenu par croissance de manière à être à réseau cristallin adapté sur un substrat de composé semiconducteur binaire sélectionné parmi un groupe constitué par le GaAs et l'InP et lesdites trois cellules d'effusion sélectionnées sont les cellules d'In, de P et d'As et lesdits premier et second semiconducteurs quaternaires sont en InGaPAs et en InAlPAs qui sont à réseau cristallin adapté audit substrat de composé semiconducteur binaire.

14. Procédé de croissance d'un semiconducteur pentanaire du groupe III-V selon la revendication 10 ou 11, dans lequel un semiconducteur pentanaire en InGaAlPSb est obtenu par croissance de manière à être à réseau cristallin adapté sur un substrat de composé semiconducteur binaire sélectionné parmi un groupe constitué par le GaAs, l'InP, l'InAs et le GaSb et lesdites trois cellules d'effusion sélectionnées sont les cellules d'In, de P et de Sb, lesdits premier et second semiconducteurs quaternaires sont en InGaPSb et en InAlPSb qui sont à réseau cristallin adapté audit substrat de composé semiconducteur binaire.

15. Procédé de croissance d'un semiconducteur pentanaire du groupe III-V selon la revendication 10 ou 11, dans lequel un semiconducteur pentanaire en GaAlPAsSb est obtenu par croissance de manière à être à réseau cristallin adapté sur un substrat de composé semiconducteur binaire sélectionné parmi un groupe constitué par le GaAs, l'InP et l'InAs et lesdites trois cellules d'effusion sélectionnées sont les cellules de P, d'As et de Sb, lesdits premier et second semiconducteurs quaternaires sont en GaPAsSb et en AlPAsSb qui sont à réseau cristallin adapté audit substrat de composé semiconducteur binaire.

**Patentansprüche**

1. Verfahren zum Aufwachsen eines quaternären Verbindungshalbleiters der III-V-Gruppe mit Gitteranpassung auf ein Substrat aus einem binären Verbindungshalbleiter der III-V-Gruppe durch MBE, welches Verfahren die folgenden Schritte umfaßt:-

(a) Vorsehen von vier Effusionszellen einschließlich einer Al-Zelle und einer Ga-Zelle und zwei ausgewählten Zellen von In-, P-, As- und Sb-Zellen,

(b) Erhitzen des Substrats auf eine vorbestimmte Temperatur durch eine Heizeinrichtung,

(c) Einstellen jeder Molekularstrahlintensität der genannten beiden ausgewählten Effusionszellen und einer der Al- und Ga-Effusionszellen aus einer ersten Gruppe, durch Änderung der Temperatur von jeder Effusionszelle derart, daß ein Betrieb der ersten Gruppe der genannten beiden ausgewählten Effusionszellen und eine der Al- und Ga-Effusionszellen einen ersten ternären Halbleiter aus drei Elementen aufwächst, der in jeder Zelle der ersten Gruppe enthalten ist, welche die Bedingung erfüllt, daß sie im wesentlichen dieselbe Gitterkonstante wie jene des III-V binären Verbindungshalbleitersubstrats hat und Einstellen einer verbleibenden Molekularstrahlintensität der anderen einen der Al- und Ga-Effusionszellen durch Änderung der Temperatur der Effusionszelle, während die Molekularstrahlintensität der ersten Gruppe von Effusionszellen aufrechterhalten wird, so daß ein Betrieb einer zweiten Gruppe der genannten beiden ausgewählten Effusionszellen und der einen anderen der Al- und Ga-Effusionszellen einen zweiten ternären Halbleiter aus drei Elementen aufwächst, der in jeder Zelle der genannten zweiten Gruppe enthalten ist, welche eine Bedingung der im wesentlichen gleichen Gitterkonstanten wie jene des III-V binären Verbindungshalbleitersubstrats erfüllt,

(d) Betreiben lediglich der genannten ersten Gruppe von Effusionszellen durch öffnen einer der Al- und Ga-Effusionszellen und durch Schließen der anderen einen der Effusionszellen, während die genannten beiden ausgewählten Effusionszellen für eine erste Wachstumsperiode geöffnet werden, welche kleiner oder gleich der Zeit ist, die zum Wachsen von drei Atomschichten erforderlich ist,

(e) Betreiben lediglich der genannten zweiten Gruppe von Effusionszellen durch öffnen der einen anderen der Al- und Ga-Effusionszellen und durch Schließen der einen der Effusionszellen, während die beiden ausgewählten Effusionszellen für eine zweite Wachstumsperiode geöffnet werden, welche kleiner oder gleich der Zeit ist, die zum Aufwachsen von drei Atomschichten erforderlich ist, und

(f) Wiederholen der Schritte (d) und (e), alternativ und ohne Unterbrechung, was zu einem Aufwachsen des quaternären Halbleiters führt, der im wesentlichen dieselbe Gitterkonstante hat wie jene des III-V-Verbindungshalbleitersubstrats, bis eine erforderliche Dicke des genannten quaternären Halbleiters erreicht ist.

2. Verfahren zum Aufwachsen eines quaternären Halbleiters der III-V-Gruppe nach Anspruch 1, bei dem die ersten und zweiten Wachstumsperioden bei den Schritten (d) und (e) ein Verhältnis haben, welches durch eine Energiebandlücke des wachsenden quaternären Halbleiters bestimmt ist, welche Engeriebandlücke einen spezifischen Wert zwischen jenem der ersten und zweiten ternären Halbleiter hat.

3. Verfahren zum Aufwachsen eines quaternären Halbleiters der III-V-Gruppe nach Anspruch 1 oder 2, bei dem ein quaternärer InGaAlAs-Halbleiter mit Gitteranpassung auf einem binären InP-Verbindungshalbleitersubstrat aufgewachsen wird, und die genannten beiden ausgewählten Effusionszellen In- und As-Zellen sind, und die genannten ersten und zweiten ternären Halbleiter InGaAs und InAlAs sind, im Gitter an das genannte InP-Substrat angepaßt.

4. Verfahren zum Aufwachsen eines quaternären Halbleiters der III-V-Gruppe nach Anspruch 1 oder 2, bei dem ein quaternärer InGaAlP-Halbleiter mit Gitteranpassung auf ein binäres GaAs-Halbleitersubstrat aufgewachsen wird, und die genannten beiden ausgewählten Effusionszellen In- und P-Zellen sind, und die genannten ersten und zweiten ternären Halbleiter InGaP und InAlP sind, im Gitter an das genannte GaAs-Substrat angepaßt.

5. Verfahren zum Aufwachsen eines quaternären Halbleiters der III-V-Gruppe nach Anspruch 1 oder 2, bei dem ein quaternärer AlGaAsSb-Halbleiter mit Gitteranpassung auf ein binäres InP-Verbindungshalbleitersubstrat aufgewachsen wird, und die genannten beiden ausgewählten Effusionszellen As- und Sb-Zellen sind, und die genannten ersten und zweiten ternären Halbleiter AlAsSb und GaAsSb sind, mit an das genannte InP-Substrat angepaßtem Gitter.

6. Verfahren zum Aufwachsen eines quaternären Halbleiters der III-V-Gruppe nach Anspruch 1 oder 2, bei dem ein quaternärer AlGaPSb-Halbleiter mit Gitteranpassung auf ein binäres InP- oder GaAs-Verbindungshalbleitersubstrat aufgewachsen wird, und die beiden ausgewählten Effusionszellen P- und Sb-Zellen sind, und die genannten ersten und zweiten ternären Halbleiter AlPSb und GaPSb sind, mit Gitteranpassung an das genannte InP- bzw. GaAs-Substrat.

7. Verfahren zum Aufwachsen eines quaternären Halbleiters der III-V-Gruppe nach einem der Ansprüche 1 bis 6, bei dem das Verfahren ferner einen zusätzlichen Schritt (f') umfaßt, entweder vor oder nach dem Schritt (f) welcher zusätzliche Schritt (f') den Schritt des Aufwachsens eines der genannten ersten oder zweiten ternären Halbleiters unter denselben Bedingungen umfaßt, wie sie bei dem Schritt (c) festgesetzt wurden, bis eine erforderliche Dicke des genannten einen der ersten und zweiten ternären Halbleiter erreicht ist, wodurch eine ternäre/quaternäre Heterostruktur erreicht wird.

8. Verfahren zum Aufwachsen eines quaternären Halbleiters der III-V-Gruppe nach einem der Ansprüche 1 bis 6, bei dem das genannte Verfahren ferner zusätzliche Schritte (f') und (f'') umfaßt, vor bzw. nach dem Schritt (f), wobei jeder der genannten Schritte (f') und (f'') einen Schritt des Aufwachsens eines der genannten ersten und zweiten ternären Halbleiter unter denselben Bedingungen, wie sie bei dem Schritt (c) gesetzt wurden, umfaßt, bis eine erforderliche Dicke von einem ersten und zweiten terären Halbleiter erreicht ist, wodurch eine quaternäre Schicht, die sandwichartig zwischen zweiten ternären Halbleiterschichten und einem Quantengraben angeordnet ist, gebildet wird.

9. Verfahren zum Bilden eines Quantengrabens nach Anspruch 7, bei dem das genannte Verfahren ferner einen Schritt des Wiederholens der genannten Schritte (f) und (f') umfaßt, alternativ mehrere Male, wodurch ein Mehrfachquantengraben gebildet wird.

10. Verfahren zum Aufwachsen eines pentanären Verbindungshalbleiters der III-V-Gruppe, mit Gitteranpassung an ein Substrat eines binären III-V-Verbindungshalbleiters durch MBE, welches Verfahren die folgenden Schritte umfaßt:

(a) Vorsehen von fünf Effusionszellen einschließlich einer Al-Zelle und einer Ga-Zelle und von drei ausgewählten Zellen aus In-, P-, As- und Sb-Zellen,

(b) Erhitzen des Substrats auf eine vorbe-

14

stimmte Termperatur durch eine Heizeinrichtung,

(c) Einstellen jeder Molekularstrahlintensität der ausgewählten drei Effusionszellen und einer der Al- und Ga-Effusionszellen von einer ersten Gruppe, durch Änderung der Temperatur jeder Effusionszelle derart, daß ein Betrieb der ersten Gruppe der drei ausgewählten Effusionszellen und einer der Al- und Ga-Effusionszellen einen ersten quaternären Halbleiter von vier Elementen aufwächst, die in jeder Zelle der ersten Gruppe enthalten sind, welche eine Bedingung der im wesentlichen gleichen Gitterkonstanten wie jener des binären III-V-Verbindungshalbleitersubstrats erfüllt und Einstellen einer verbleibenden Molekularstrahlintensität der einen anderen der Al- und Ga-Effusionszellen durch Ändern der Temperatur der Effusionszelle, während die Molekularstrahlintensität der ersten Gruppe von Effusionszellen aufrechterhalten wird, so daß ein Betrieb der genannten zweiten Gruppe der genannten drei ausgewählten Effusionszellen und der einen anderen der Al- und Ga-Effusionszellen einen zweiten quaternären Halbleiter aus vier Elementen aufwächst, die in jeder Zelle der genannten zweiten Gruppe enthalten sind, welche eine Bedingung der im wesentlichen gleichen Gitterkonstaten wie jener des binären III-V-Verbindungshalbleitersubstrats erfüllt,

(d) Betreiben lediglich der genannten ersten Gruppe von Effusionszellen durch öffnen einer der Al- und Ga-Effusionszellen und durch Schließen der anderen einen der Effusionszellen, während die genannten drei ausgewählten Effusionszellen für eine erste Wachstumsperiode geöffnet werden, welche kleiner oder gleich der Zeit ist, die zum Wachsen der drei Atomschichten erforderlich ist,

(e) Betreiben lediglich der genannten zweiten Gruppe der Effusionszellen durch öffnen der einen anderen der Al- und Ga-Effusionszellen und durch Schließen der einen der Effusionszellen, während die genannten drei ausgewählten Effusionszellen für eine zweite Wachstumsperiode geöffnet werden, welche kleiner oder gleich der Zeit ist, die zum Wachsen der drei Atomschichten erforderlich ist, und

(f) Wiederholen der Schritte (d) und (e) alternativ ohne Unterbrechung, was zu einem Wachsen des pentanären Halbleiters führt, der im wesentlichen dieselbe Gitterkonstante wie jene des III-V-Verbindungshalbleitersubstrats hat, bis eine erforderliche Dicke des genannten quaternären Halbleiters erzielt wird.

11. Verfahren zum Aufwachsen eines pentanären Halbleiters der III-V-Gruppe nach Anspruch 10, bei dem die ersten und zweiten Wachstumsperioden bei den Schritten (d) und (e) ein Verhältnis haben, das durch eine Energiebandlücke von dem genannten wachsenden pentanären Halbleiter bestimmt ist, welche Energiebandlücke einen spezifizierten Wert zwischen jenen der ersten und zweiten quaternären Halbleiter hat.

12. Verfahren zum Aufwachsen eines pentanären Halbleiters der III-V-Gruppe nach Anspruch 10 oder 11, bei dem ein pentanärer InGaAlAsSb-Halbleiter mit Gitteranpassung auf ein binäres Verbindungshalbleitersubstrat von irgendeinem ausgewählt aus der Gruppe InP, InAs und GaSb aufgewachsen wird, und die genannten drei ausgewählten Effusionszellen die In-, As- und Sb-Zellen sind, und die genannten ersten und zweiten quaternären Halbleiter InGaAsSb und InAlAsSb sind, im Gitter angepaßt an das genannte binäre Halbleitersubstrat.

13. Verfahren zum Aufwachsen eines pentanären Halbleiters der III-V-Gruppe nach Anspruch 10 oder 11, bei dem der pentanäre InGaAlPAs-Halbleiter mit Gitteranpassung auf ein binäres Verbindungshalbleitersubstrat von einem ausgewählt aus der Gruppe GaAs und InP aufgewachsen wird und die genannten drei ausgewählten Effusionszellen In-, P- und As-Zellen sind, und die genannten ersten und zweiten quaternären Halbleiter InGaPAs und InAlPAs sind, im Gitter angepaßt an das genannte binäre Halbleitersubstrat.

14. Verfahren zum Aufwachsen eines pentanären Halbleiters der III-V-Gruppe nach Anspruch 10 oder 11, bei dem ein pentanärer InGaAlPSb-Halbleiter mit Gitteranpassung auf ein binäres Verbindungshalbleitersubstrat aufgewachsen wird, ausgewählt aus der Gruppe von GaAs, InP, InAs und GaSb, und die genannten drei ausgewählten Effusionszellen In-, P- und Sb-Zellen sind, und die genannten ersten und zweiten quaternären Halberleiter InGaPSb und InAlPSb sind, mit Gitteranpassung an das genannte binäre Verbindungshalbleitersubstrat.

15. Verfahren zum Aufwachsen eines pentanären Halbleiters der III-V-Gruppe nach Anspruch 10 oder 11, bei dem ein pentanärer GaAlPAsSb-Halbleiter mit Gitteranpassung auf eine binäres Verbindungshalbleitersubstrat aufgewachsen wird, ausgewählt aus der Gruppe von GaAs, InP und InAs, und die genannten drei ausgewählten Effusionszellen P-, As- und Sb-Zellen sind, und die genannten ersten und zweiten quaternären Halbleiter GaPAsSb und AlPAsSb sind, im Gitter angepaßt an das genannte binäre Verbindungshalbleitersubstrat.

FIG. 1　　PRIOR ART

FIG. 2

at 300°K

Lattice Constant (Å)

Bandgap (eV)

Wavelength (μm)

AlP
GaP
AlAs
GaAs
InP
AlSb
GaSb
InAs
InSb

N (In_{0.52} Al_{0.48} As)

M (In_{0.53} Ga_{0.47} As)

A
B
C
D

FIG. 4

FIG. 3

45  $In_{0.52} Al_{0.48} As$

44  $(In_{0.53} Ga_{0.47} As)_{1/2} \cdot (In_{0.52} Al_{0.48} As)_{1/2}$

43  $In_{0.52} Al_{0.48} As$

42  $In_{0.53} Ga_{0.47} As$

41  $Fe$ Doped $InP$

## FIG. 5

$(In_{0.53} Ga_{0.47} As)_{1/2} \cdot (In_{0.52} Al_{0.48} As)_{1/2}$

43        44        45
$InAlAs$            $InAlAs$

42
$InGaAs$

$E_C$

$E_V$

## FIG. 6

20

FIG. 7